# EUROPEAN PATENT SPECIFICATION

(11) **EP 3 882 996 B1**
(45) Date of publication and mention of the grant of the patent: **27.03.2024**
(21) Application number: 19884580.2
(22) Date of filing: 07.11.2019
(51) Int. Cl.: H01M 10/0562, H01M 10/0585, H01M 10/058, H01M 4/48, H01M 4/52

(54) **SECONDARY BATTERY AND MANUFACTURING METHOD THEREFOR**
SEKUNDÄRBATTERIE UND HERSTELLUNGSVERFAHREN DAFÜR
BATTERIE SECONDAIRE ET SON PROCÉDÉ DE FABRICATION

(30) Priority: 13.11.2018 JP 2018212875
(43) Date of publication of application: 22.09.2021
(73) Proprietor: Kabushiki Kaisha Nihon Micronics, Musashino-shi Tokyo 1808508 (JP)
(72) Inventor: SAITO, Tomokazu, Musashino-shi, Tokyo 180-8508 (JP); KUDOH, Takuo, Musashino-shi, Tokyo 180-8508 (JP)
(74) Representative: INNOV-GROUP
(86) International application number: PCT/JP2019/043733
(87) International publication number: WO 2020/100722

(56) References cited:
- JP-A- 2016 127 166
- JP-A- 2016 127 166
- JP-A- 2017 059 516
- JP-A- 2017 212 430
- JP-A- 2017 212 430
- JP-A- 2018 022 719
- JP-A- 2018 022 719
- JP-A- 2018 152 532

## Description

### Technical Field

The present disclosure relates to a technique for improving the performance of a secondary battery

### Background Art

Patent Literature 1 discloses a power storage element provided with a power storage layer including a mixture of an insulating material and n-type semiconductor particles between a first electrode and a second electrode. A p-type semiconductor layer is disposed between the power storage layer and the second electrode. Further, a leak suppression layer is disposed between the p-type semiconductor layer and the power storage layer. The leakage suppression layer is composed of at least one element selected from silicon dioxide, aluminum oxide, and magnesium oxide.

Patent Literature 2 discloses a power storage element provided with a power storage layer including a mixture of an insulating material and n-type semiconductor particles between a first electrode and a second electrode. A p-type semiconductor layer is disposed between the power storage layer and the second electrode. Further, a diffusion suppression layer having a resistivity of 1000 µΩ·cm or less is disposed between the first electrode and the power storage layer. The diffusion suppression layer is formed of nitride, carbide, and boride.

Other prior art are known from : JP2017212430A, JP2016127166A and JP2018022719A. JP2017212430A and corresponding EP 3 460 862 A1 discloses a secondary battery having the features of the preamble of Claim 1.

### Citation List

### Patent Literature

Patent Literature 1: Japanese Unexamined Patent Application Publication No. 2016-82125
Patent Literature 2: Japanese Unexamined Patent Application Publication No. 2016-91931

### Summary of Invention

### Technical Problem

In such a secondary battery, further improvement in the performance is desired.

An object of the present disclosure is to improve the performance of a secondary battery.

### Solution to Problem

The invention is exposed in the enclosed set of claims.

An example aspect of an embodiment is a secondary battery according to independent device claim 1.

In the above secondary battery, the third layer includes tantalum oxide and may be an amorphous layer including tantalum oxide or a nanoparticle layer including a plurality of tantalum oxide nanoparticles.

In the above secondary battery, a thickness of the third layer may be 50 nm or more and 800 nm or less.

In the above secondary battery, a layer including nickel oxide or nickel hydroxide is formed between the fourth layer and the second electrode.

In the above secondary battery, the fourth layer is mainly composed of SiOx that is the second insulating material, and SnOx is added to the fourth layer.

In the above secondary battery, the first insulating material may be SiOx, and the second n-type oxide semiconductor material may be TiO₂.

In the above secondary battery, the first n-type oxide semiconductor material may be TiO₂.

Another example aspect of the embodiment is a method of manufacturing a secondary battery according to independent method claim 6.

In the above method, in the forming of the third layer, an amorphous layer including tantalum oxide or a nanoparticle layer including a plurality of tantalum oxide nanoparticles may be formed by sputter deposition, vapor deposition, or ion plating.

### Advantageous Effects of Invention

According to the present disclosure, it is possible to provide a technique of improving the performance of a secondary battery.

### Brief Description of Drawings

Fig. 1 schematically shows a laminated structure of a secondary battery according to the first embodiment;
Fig. 2 is a graph showing a remaining rate of energy density after one week in the secondary battery according to the first embodiment;
Fig. 3 shows a surface SEM photograph of a tantalum oxide film;
Fig. 4 shows an X-ray diffraction pattern in a sample with a tantalum oxide film formed on a surface;
Fig. 5 is a flowchart showing a method of manufacturing the secondary battery according to the first embodiment; and
Fig. 6 schematically shows a laminated structure of a secondary battery according to a second embodiment.

### Description of Embodiments

An example of embodiments of the present disclosure will be described below with reference to the drawings. The following description shows preferred embodiments of the present disclosure, and the technical scope of the present disclosure is not limited to the following embodiments.

### [First embodiment]

### (Laminated structure of secondary battery)

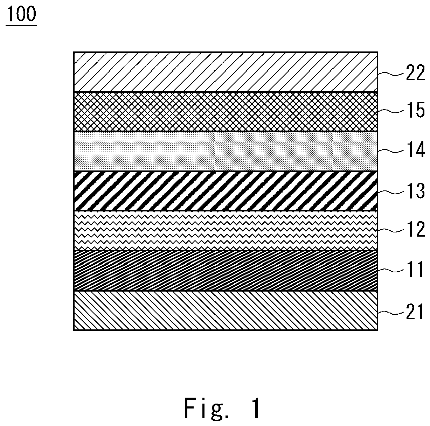

A basic configuration of a secondary battery according to this embodiment will be described below with reference to Fig. 1. Fig. 1 is a cross-sectional view schematically showing a laminated structure of the secondary battery 100.

In Fig. 1, the secondary battery 100 has a laminated structure in which a first electrode 21, a first layer 11, a second layer 12, a third layer 13, a fourth layer 14, a fifth layer 15, and a second electrode 22 are laminated in this order.

### [First electrode 21]

The first electrode 21 becomes a negative electrode of the secondary battery 100. The first electrode 21 is a conductive sheet or a conductive substrate functioning as a base material. As the first electrode 21, for example, a metal foil sheet such as a SUS sheet or an aluminum sheet can be used. Note that it is also possible to prepare a base material formed of an insulator and form the first electrode 21 on the substrate. When the first electrode 21 is formed on an insulating base material, a metal material such as tungsten (W), chromium (Cr), or titanium (Ti) can be used as the material of the first electrode 21. As the material of the first electrode 21, an alloy film including aluminum (Al), silver (Ag) or the like may be used. When the first electrode 21 is formed on the base material, the first electrode 21 can be formed in the same manner as the second electrode 22 described later.

### [First layer 11]

The first layer 11 is disposed on the first electrode 21. The first layer 11 is disposed on the first electrode 21 on the side of the second electrode 22. The first layer 11 is formed in contact with the first electrode 21. The thickness of the first layer 11 is, for example, about 50 nm to 200 nm.

The first layer 11 includes an n-type oxide semiconductor material (a first n-type oxide semiconductor material). The first layer 11 is an n-type oxide semiconductor layer formed with a predetermined thickness. As the first layer 11, for example, titanium dioxide (TiO₂), tin oxide (SnO₂), or zinc oxide (ZnO) can be used. For example, the first layer 11 is an n-type oxide semiconductor layer formed on the first electrode 21 by sputtering, vapor deposition or the like. As the material of the first layer 11, it is particularly preferable to use titanium dioxide (TiO₂).

### [Second layer 12]

The second layer 12 functioning as a negative electrode active material layer is disposed on the first layer 11. The second layer 12 is disposed on the first layer 11 on the side of the second electrode 22. The second layer 12 is formed in contact with the first layer 11. The thickness of the second layer 12 is, for example, 200 nm to 1000 nm.

The second layer 12 includes an insulating material (a first insulating material). A silicone resin can be used as the first insulating material. For example, as the first insulating material, it is preferable to use a silicon compound (silicone) having a main skeletone bonded by siloxane such as a silicon oxide. Therefore, the second layer 12 includes silicon oxide (SiOₓ) as the first insulating material.

The second layer 12 includes an n-type oxide semiconductor material (a first insulating material) in addition to an insulating material (a second n-type oxide semiconductor material). That is, the second layer 12 is formed of a mixture of the first insulating material and the second n-type oxide semiconductor material. For example, a fine particles n-type oxide semiconductor can be used as the second n-type oxide semiconductor material.

For example, the second layer 12 is formed of silicon oxide and titanium dioxide with the second n-type oxide semiconductor material used as titanium dioxide. In addition, as the n-type oxide semiconductor material that can be used for the second layer 12, tin oxide (SnO₂), zinc oxide (ZnO), and magnesium oxide (MgO) are preferable. A combination of two, three, or all of titanium dioxide, tin oxide, zinc oxide, and magnesium oxide may also be used.

The second n-type oxide semiconductor material included in the second layer 12 and the first n-type oxide semiconductor material included in the first layer 11 may be the same or different. For example, when the first n-type oxide semiconductor material included in the first layer 11 is titanium oxide, the second n-type oxide semiconductor material of the second layer 12 may be titanium oxide or an n-type oxide semiconductor material other than titanium oxide.

### [Third layer 13]

The third layer 13 functioning as a solid electrolyte is disposed on the second layer 12. The third layer 13 is disposed on the second layer 12 on the side of the second electrode 22. The third layer 13 is formed in contact with the second layer 12. The thickness of the third layer 13 is preferably 50 nm or more and 800 nm or less.

The third layer 13 functions as a buffer layer for adjusting the movement of H⁺ and electrons (e⁻). The third layer 13 is a layer including tantalum oxide. For example, the third layer 13 can be formed of a tantalum oxide film (TaOₓ film) having a predetermined thickness. Specifically, the third layer 13 is a TaOₓ layer formed on the second layer 12 by sputtering or the like. The third layer 13 is preferably an amorphous layer including tantalum oxide. Alternatively, the third layer 13 is preferably a nanoparticle layer including a plurality of tantalum oxide nanoparticles.

### [Fourth layer 14]

The fourth layer 14 functioning as a positive electrode active material layer or a solid electrolyte layer is disposed on the third layer 13. The fourth layer 14 is disposed on the third layer 13 on the side of the second electrode 22. The fourth layer 14 is formed in contact with the third layer 13. The thickness of the fourth layer 14 is 100 nm to 150 nm. The fourth layer 14 may also be formed with a thickness in the range of 50 nm to 250 nm. More desirably, the fourth layer 14 may be formed with a thickness in the range from 150 nm to 200 nm.

The fourth layer 14 functions as a buffer layer for adjusting the movement of H ⁺ and electrons (e⁻). The fourth layer 14 is a layer including an insulating material (a second insulating material). The fourth layer 14 includes silicon oxide (SiOₓ) as the second insulating material. Specifically, the fourth layer 14 is a layer mainly composed of silicon oxide (SiOₓ) as the second insulating material.

The fourth layer 14 may be composed of only the second insulating material. Alternatively, in the fourth layer 14, a conductivity adjusting material may be added to the second insulating material. The mobility of H⁺ and e⁻ can be further adjusted by adding the conductivity adjusting material to the second insulating material. That is, the fourth layer 14 may be a mixture layer in which the conductivity adjusting material and an insulating material are mixed.

The conductivity adjusting material may include an n-type oxide semiconductor material (a third n-type oxide semiconductor material) or oxide of metal. For example, the fourth layer 14 may include at least one element selected from the group consisting of oxide of Ti, Sn, Zn, Nb, or Mg as the conductivity adjusting material. By using oxide of Sn, Zn, Ti, Nb, or Mg as the conductivity adjusting material, the fourth layer 14 can be formed so as to be thick and be able to withstand high electrical voltage.

According to the present invention, tin oxide (SnOₓ) is used as the third n-type oxide semiconductor material included in the fourth layer 14. In this case, the fourth layer 14 includes a mixture of silicon oxide and tin oxide. In the fourth layer 14, the third n-type oxide semiconductor material is added to silicon oxide, silicon nitride, or silicone oil. The n-type oxide semiconductor is dispersed in silicon dioxide which is the second insulating material.

In the fourth layer 14, the third n-type oxide semiconductor material may include one or more kinds of oxide selected from tin (SnOx) oxide, zinc (ZnO) oxide, titanium oxide (TiOx), and niobium (NbOx) oxide.

The second n-type oxide semiconductor material included in the second layer 12 and the third n-type oxide semiconductor material contained in the fourth layer 14 may be the same material or different materials. For example, if the third n-type oxide semiconductor material in the fourth layer 14 is tin oxide, the second n-type oxide semiconductor material of the second layer 12 may be tin oxide or an n-type oxide semiconductor material other than tin oxide.

### [Fifth layer 15]

The fifth layer 15 is disposed on the fourth layer 14. The fifth layer 15 is disposed on the fourth layer 14 on the side of the second electrode 22. The fifth layer 15 is formed in contact with the fourth layer 14. The thickness of the fifth layer 15 is 100 nm or more. The fifth layer 15 may also be formed with a thickness within the range of 100 nm to 400 nm.

The fifth layer 15 is formed on the fourth layer 14. The fifth layer 15 includes a p-type oxide semiconductor material. The fifth layer 15 is, for example, a nickel oxide (NiO) layer. The fifth layer 15 is formed on the fourth layer 14 by sputtering using Ni or NiO as a target.

### [Second electrode 22]

The second electrode 22 is disposed on the fifth layer 15. The second electrode 22 is formed in contact with the fifth layer 15. The second electrode 22 may be formed of a conductive film. A metal material such as chromium (Cr) or copper (Cu) may be used as the material of the second electrode 22. An alloy film including aluminum (Al), silver (Ag) or the like may also be used as the material of the second electrode 22. Examples of the method of forming the alloy film include the vapor phase film deposition method such as sputtering, ion plating, electron beam vapor deposition, vacuum deposition, and chemical vapor deposition. The metal electrode can be formed by electrolytic plating, electroless plating or the like. As the metal used for plating, copper, a copper alloy, nickel, silver, gold, zinc, tin or the like can be commonly used. For example, the second electrode 22 is an Al film having a thickness of 300 nm.

In this manner, the third layer 13 including tantalum oxide is disposed between the second layer 12 and the fourth layer 14. With this configuration, the performance of the secondary battery 100 can be improved. The performance of the secondary battery improved by this configuration is described below using measurement data measured on an actual sample.

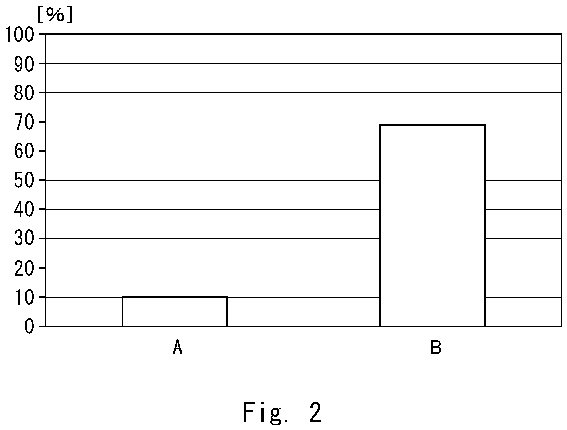

Fig. 2 is a graph showing the self-discharge characteristics of the two samples A and B. The sample B is an example including the third layer 13. The sample A is a comparative example not including third layer 13. That is, in the sample A, the second layer 12 is directly disposed on the fourth layer 14. Fig. 2 shows the results measurement of the self-discharge characteristics one week after full charge. That is, in Fig. 2, the remaining capacities after the secondary batteries are left for one week are shown as the remaining rates (%), provided that the remaining rate is 100% immediately after charging.

The remaining rate of the sample B is higher than that of the sample A. Therefore, the secondary battery according to this embodiment including the third layer 13 can maintain a high remaining rate. The reason for such a result is considered to be because electrical resistances of an interface between the third layer 13 (the solid electrolyte) and the second layer 12 (the negative electrode active material) and an interface between the third layer 13 (the solid electrolyte) and the fourth layer 14 (the positive electrode active material) are increased, and thus the electron leakage can be prevented or minimized. Therefore, according to this embodiment, it is possible to prevent or minimize a rapid decrease in the energy density due to the secondary battery being left after charging. According to the configuration of this embodiment, for example, it is possible to achieve the remaining rate of about 80% or more after the secondary battery is left for six hours. Further, it is possible to achieve the remaining rate of about 80% or more after 24 hours, and the remaining rate of about 68% after 168 hours.

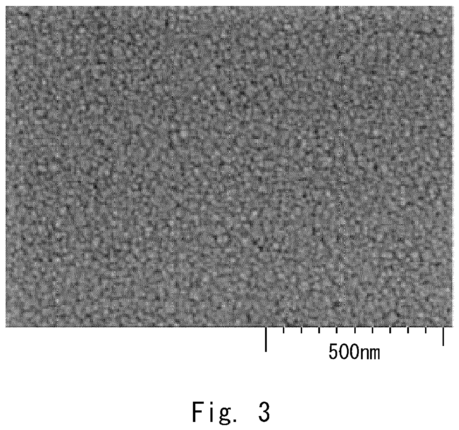

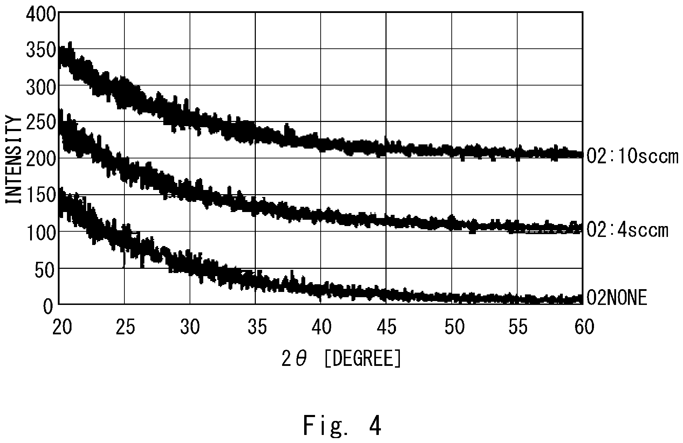

Fig. 3 shows a surface SEM (Scanning Electron Microscope) photograph of the third layer 13. Fig. 4 shows an X-ray diffraction pattern (spectrum) with the third layer 13 exposed. In Fig. 4, the horizontal axis represents a diffraction angle 20 (an angle between an incident X-ray direction and a diffracted x-ray direction), and the vertical axis represents a diffraction intensity (a.u). In this embodiment, X-ray diffraction measurement is performed by the grazing incidence X-ray diffraction method using CuKα rays each having a wavelength of 1.5418 angstroms. Fig. 4 shows data of three samples formed by changing the flow rate of an oxygen gas (O₂) to 0 sccm, 4 sccm, and 10 sccm at the time of sputter deposition. Figs. 3 and 4 show results of measurement when a TaOₓ film having a thickness of 400 nm is formed as the third layer 13.

As can be seen from the SEM photograph of Fig. 3, no particles having a size of 0.1 µm or larger are formed in the third layer 13. Furthermore, in Fig. 4, no diffraction peak appears. Therefore, it can be seen that the TaOₓ film is in an amorphous state or in a state where a plurality of tantalum oxide nanoparticles are deposited. By forming the TaOₓ film having no crystal structure as the third layer 13, self-discharge can be prevented or minimized. A high-performance secondary battery can be realized.

### (Manufacturing process)

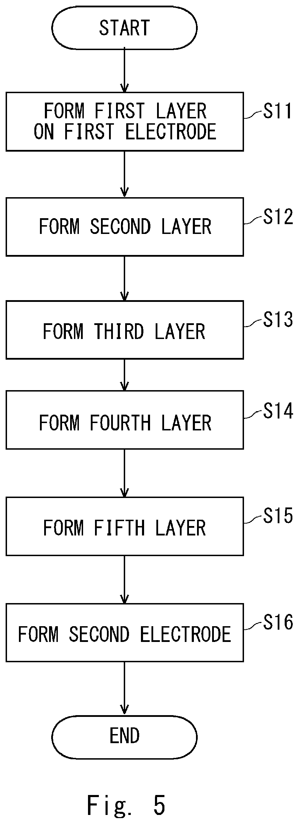

Next, a method of manufacturing the secondary battery 100 according to this embodiment will be described with reference to Fig. 5. Fig. 5 is a flowchart showing a method of manufacturing the secondary battery 100.

First, the first layer 11 is formed on the first electrode 21 (S11). The first layer 11 includes the first n-type oxide semiconductor material as described above. For example, in the first layer 11, a TiO₂ film can be formed as the first layer 11 by sputtering using Ti or TiO as a target. The first layer 11 can be a TiO₂ film having a thickness of 50 nm to 200 nm. The first electrode 21 is, for example, a tungsten electrode.

Next, the second layer 12 is formed on the first layer 11 (S12). The second layer 12 can be formed by the coating pyrolysis process. First, a coating liquid is prepared by mixing a solvent with a mixture of a precursor of titanium oxide, tin oxide, or zinc oxide and silicone oil. An example in which the second layer 12 is formed of silicon oxide as the first insulating material and titanium oxide as the second n-type oxide insulating material will be described. In this case, the fatty acid titanium can be used as the precursor of the titanium oxide. Fatty acid titanium and silicone oil are stirred together with a solvent to prepare the coating liquid.

The coating liquid is applied onto the first layer 11 by the spin coating method, the slit coating method or the like. Specifically, the coating liquid is applied by a spin coating apparatus at a rotational speed of 500 to 3000 rpm.

Then, the coating film is dried, baked, and irradiated with UV light, so that the second layer 12 can be formed on the first layer 11. For example, the workpiece is dried on a hot plate after the coating liquid is applied. The drying temperature on the hot plate is about 30 °C to 200°C, and the drying time is about 5 minutes to 30 minutes. After the workpiece is dried, the workpiece is baked in the atmosphere using a baking furnace. The baking temperature is, for example, about 300 °C to 600 °C, and the baking time is about 10 minutes to 60 minutes.

Thus, an aliphatic acid salt is decomposed to form a fine particle layer of titanium dioxide covered with a silicone insulating film. Specifically, the fine particle layer has a structure in which a metal salt of the titanium dioxide coated with silicone is buried in a silicone layer. The baked coating film is irradiated with UV light by a low-pressure mercury lamp. The UV irradiation time is 10 to 60 minutes.

When the second n-type oxide semiconductor is titanium oxide, for example, titanium stearate can be used as another example of the precursor. Titanium oxide, tin oxide, and zinc oxide are formed by decomposing an aliphatic acid salt which is a precursor of a metal oxide. For titanium oxide, tin oxide, zinc oxide, and the like, it is also possible to use fine particles of an oxide semiconductor without using a precursor. Nanoparticles of titanium oxide or zinc oxide are mixed with silicone oil to produce a mixture. Further, a solvent is mixed with the mixture to produce the coating liquid.

The third layer 13 is formed on the second layer 12 (S13). The third layer 13 includes the tantalum oxide as described above. For example, the third layer 13 can be formed by sputtering using Ta or Ta₂O₅ as a target. Alternatively, instead of the sputter deposition, the film formation method such as the vapor deposition or ion plating can be used. The TaOₓ film can be formed as the third layer 13 by using these film forming methods. In the sputter deposition, only an argon (Ar) gas may be used, or an oxygen (O₂) gas may be added to the argon gas and then supplied. The third layer 13 may be a TaOₓ film having a thickness of 50 nm or more and 800 nm or less. Here, as the third layer 13, it is preferable to form an amorphous TaOₓ film or a TaOₓ film in which a plurality of tantalum oxide nanoparticles are deposited.

The fourth layer 14 is formed on the third layer 13 (S14). The fourth layer 14 can be formed in the same manner as the second layer 12. Specifically, fatty acid tin and silicone oil are stirred together with a solvent to prepare a chemical solution. This chemical solution is applied onto the third layer 13 using the spin coating apparatus. The rotational speed is, for example, about 500 to 3000 rpm. After the chemical solution is applied, the workpiece is dried on the hot plate. The drying temperature on the hot plate is, for example, about 30 °C to 200 °C, and the drying time is, for example, about 5 to 30 minutes.

After the workpiece is dried, the workpiece is baked. The baking furnace is used to bake the workpiece after the workpiece is dried, and the workpiece is baked in the atmosphere. The baking temperature is, for example, about 300 °C to 600 °C, and the baking time is, for example, about 10 to 60 minutes. After the workpiece is baked, the workpiece is irradiated with UV light by the low-pressure mercury lamp. The UV irradiation time is, for example, about 10 to 100 minutes. The thickness of the fourth layer 14 after the UV irradiation is, for example, about 100 nm to 300 nm.

For the tin oxide, it is also possible to use fine particles of an oxide semiconductor without using a precursor. Tin oxide nanoparticles are mixed with silicone oil to produce a mixture. Further, a solvent is mixed with the mixture to produce the coating liquid.

Another example of the step of forming the fourth layer 14 will be described. In this example, a layer made of only the second insulating material is used as the fourth layer 14. That is, a method of forming the fourth layer 14 not including the third n-type oxide semiconductor material will be described below.

The silicone oil is stirred together with a solvent to prepare a chemical solution. This chemical solution is applied onto the third layer 13 using the spin coating apparatus. Here, the spin coating apparatus is used. The rotational speed of the spin coating apparatus is, for example, about 500 to 3000 rpm. After the chemical solution is applied, the workpiece is dried on the hot plate. The drying temperature on the hot plate is, for example, about 50 °C to 200 °C, and the drying time is, for example, about 5 to 30 minutes.

After the workpiece is dried, the workpiece is baked. The baking furnace is used to bake the workpiece after the workpiece is dried, and the workpiece is baked in the atmosphere. The baking temperature is, for example, about 300 °C to 600 °C, and the baking time is, for example, about 10 to 60 minutes. After the workpiece is baked, the workpiece is irradiated with UV light by the low-pressure mercury lamp. The UV irradiation time is, for example, about 10 to 60 minutes. The thickness of the fourth layer 14 after the UV irradiation is, for example, about 10 nm to 100 nm.

Next, the fifth layer 15 is formed on the fourth layer 14 (S15). The fifth layer 15 can be formed by sputtering using Ni or NiO as a target.

The second electrode 22 is formed on the fifth layer 15 (S16). Examples of the method of forming the second electrode 22 include the vapor phase film deposition method such as sputtering, ion plating, electron beam vapor deposition, vacuum deposition, and chemical vapor deposition. Note that the second electrode 22 may be partially formed using a mask. The second electrode 22 can be formed by the electrolytic plating method, the electroless plating method or the like. As the metal used for the plating, copper, a copper alloy, nickel, silver, gold, zinc, tin or the like can commonly be used. For example, the second electrode 22 is an Al film having a thickness of 300 nm.

With the above-described manufacturing method, the high-performance secondary battery 100 can be manufactured with high productivity.

### [Second embodiment]

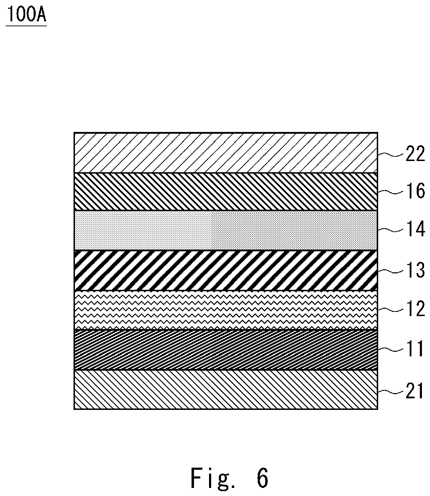

A configuration of a secondary battery 100A according to a second embodiment will be described with reference to Fig. 6. Fig. 6 is a cross-sectional view showing the configuration of the secondary battery 100A. In this embodiment, a sixth layer 16 is provided in place of the fifth layer 15. The secondary battery 100A has a laminated structure in which the first electrode 21, the first layer 11, the second layer 12, the third layer 13, the fourth layer 14, the sixth layer 16, and the second electrode 22 are laminated in this order. The structure other than the sixth layer 16 is the same as that of the first embodiment, and thus the description of the secondary battery 100A will be omitted as appropriate.

The sixth layer 16 includes nickel hydroxide (Ni(OH)₂). Specifically, a nickel hydroxide layer formed with a predetermined thickness becomes the sixth layer 16. The thickness of the sixth layer 16 is preferably 100 nm or more and 400 nm or less.

As the method of forming the sixth layer 16, the chemical bath deposition (CBD) method, the dip-coating method, or the mist CVD method can be used. In the chemical bath deposition method or the dip-coating method, a solution including nickel ions is used. Specifically, an alkaline aqueous solution is reacted with an aqueous solution including nickel ions to deposit a nickel hydroxide layer on the surface of the fourth layer 14.

In this way, the nickel hydroxide film is directly formed on the fourth layer 14 by the chemical bath deposition method, the dip-coating method or the like. Since the sixth layer 16 can be formed with a sufficient thickness, a secondary battery having a large storage capacity can be realized. That is, in the configuration in which nickel oxide is electrically converted into nickel hydroxide, it is difficult to obtain a sufficient storage capacity, because the film is thin.

The secondary battery may include both the fifth layer 15 and the sixth layer (the nickel hydroxide layer) 16. In this case, the sixth layer 16 may be formed on the fifth layer 15, and the fifth layer 15 may be formed on the sixth layer 16. Further, two NiO layers may be provided between the second electrode 22 and the fourth layer (SiOx + SnOx) 14, and the nickel hydroxide layer may be provided between the two NiO layers. A layer other than the above-described first layer 11 to the sixth layer 16 may be added.

This application claims priority on the basis of Japanese Patent Application No. 2018 -212875, filed November 13, 2018.

### Reference Signs List

- 100: SECONDARY BATTERY
- 11: FIRST LAYER (n-TYPE OXIDE SEMICONDUCTOR LAYER)
- 12: SECOND LAYER (SiOx + TiOx)
- 13: THIRD LAYER (TaOₓ)
- 14: FOURTH LAYER (SiOx + SnOx)
- 15: FIFTH LAYER (NICKEL OXIDE LAYER)
- 16: SIXTH LAYER (NICKEL HYDROXIDE LAYER)
- 21: FIRST ELECTRODE
- 22: SECOND ELECTRODE

## Claims

1. A secondary battery (100) comprising:
a first electrode (21);
a second electrode (22);
a first layer (11) disposed between the first electrode and the second electrode and including a first n-type oxide semiconductor material;
a second layer (12) disposed on the first layer (11) and including a second n-type oxide semiconductor material and a first insulating material;
a third layer (13) disposed on the second layer; and
a fourth layer (14) disposed on the third layer and including a second insulating material; and
a layer (15; 16) including nickel oxide or nickel hydroxide formed between the fourth layer (14) and the second electrode (22),
wherein the fourth layer (14) is mainly composed of SiOx that is the second insulating material,
**characterized in that** :
- the third layer (13) includes tantalum oxide, and
- SnOx is added to the fourth layer.

2. The secondary battery according to Claim 1, wherein
the third layer (13) is an amorphous layer including tantalum oxide or a nanoparticle layer including a plurality of tantalum oxide nanoparticles.

3. The secondary battery according to Claim 1 or 2, wherein
a thickness of the third layer (13) is 50 nm or more and 800 nm or less.

4. The secondary battery according to any one of Claims 1 to 3, wherein
the first insulating material is SiOx, and
the second n-type oxide semiconductor material is TiO₂.

5. The secondary battery according to any one of Claims 1 to 4, wherein
the first n-type oxide semiconductor material is TiO₂.

6. A method of manufacturing a secondary battery (100) comprising:
forming (S11) a first layer (11) including a first n-type oxide semiconductor material on a first electrode (21);
forming (S12) a second layer (12) including a second n-type oxide semiconductor material and a first insulating material on the first layer (11);
forming (S13) a third layer (13) on the second layer;
forming (S14) a fourth layer (14) including a second insulating material on the third layer (13), the fourth layer (14) being mainly composed of SiOx that is the second insulating material; and
forming (S16) a second electrode (22) on the fourth layer (14),
wherein a layer (15; 16) including nickel oxide or nickel hydroxide is formed between the fourth layer (14) and the second electrode (22),
**characterized in that** :
- forming (S13) the third layer (13) comprises forming a third layer including tantalum oxide, and
- SnOx is added to the fourth layer.

7. The method according to Claim 6, wherein
in the forming (S13) of the third layer, an amorphous layer including tantalum oxide or a nanoparticle layer including a plurality of tantalum oxide nanoparticles is formed by sputter deposition, vapor deposition, or ion plating.

## Patentansprüche

1. Sekundärbatterie (100), umfassend:
eine erste Elektrode (21);
eine zweite Elektrode (22);
eine erste Schicht (11), die zwischen der ersten Elektrode und der zweiten Elektrode angeordnet ist und ein erstes n-Oxid-Halbleitermaterial aufweist;
eine zweite Schicht (12), die auf der ersten Schicht (11) angeordnet ist und ein zweites n-Oxid-Halbleitermaterial und ein erstes Isoliermaterial aufweist;
eine dritte Schicht (13), die auf der zweiten Schicht angeordnet ist;
eine vierte Schicht (14), die auf der dritten Schicht angeordnet ist und ein zweites Isoliermaterial aufweist; und
eine Schicht (15; 16), die Nickeloxid oder Nickelhydroxid aufweist und die zwischen der vierten Schicht (14) und der zweiten Elektrode (22) ausgebildet ist,
wobei die vierte Schicht (14) hauptsächlich aus SiOx besteht, das das zweite isolierende Material ist,
**dadurch gekennzeichnet, dass**:
- die dritte Schicht (13) Tantaloxid aufweist, und
- SnOx zur vierten Schicht hinzugefügt wird.

2. Sekundärbatterie gemäß Anspruch 1, wobei
die dritte Schicht (13) eine amorphe Schicht, die Tantaloxid aufweist, oder eine Nanopartikelschicht, die mehrere Tantaloxid-Nanopartikel aufweist, ist.

3. Sekundärbatterie gemäß Anspruch 1 oder 2, wobei
die Dicke der dritten Schicht (13) 50 nm oder mehr und 800 nm oder weniger beträgt.

4. Sekundärbatterie gemäß einem der Ansprüche 1 bis 3, wobei
das erste Isoliermaterial SiOx ist und
das zweite n-Oxid-Halbleitermaterial TiO₂ ist.

5. Sekundärbatterie gemäß einem der Ansprüche 1 bis 4, wobei das erste n-Oxid-Halbleitermaterial TiO₂ ist.

6. Verfahren zur Herstellung einer Sekundärbatterie (100), umfassend:
Ausbilden (S11) einer ersten Schicht (11), die ein erstes n-Oxid-Halbleitermaterial auf einer ersten Elektrode (21) aufweist;
Ausbilden (S12) einer zweiten Schicht (12), die ein zweites n-Oxid-Halbleitermaterial und ein erstes Isoliermaterial aufweist, auf der ersten Schicht (11);
Ausbilden (S13) einer dritten Schicht (13) auf der zweiten Schicht;
Ausbilden (S14) einer vierten Schicht (14), die ein zweites Isoliermaterial aufweist, auf der dritten Schicht (13), wobei die vierte Schicht (14) hauptsächlich aus SiOx besteht, das das zweite Isoliermaterial ist; und
Ausbilden (S16) einer zweiten Elektrode (22) auf der vierten Schicht (14),
wobei eine Schicht (15; 16), die Nickeloxid oder Nickelhydroxid aufweist, zwischen der vierten Schicht (14) und der zweiten Elektrode (22) ausgebildet wird,
**dadurch gekennzeichnet, dass**
- das Ausbilden (S13) der dritten Schicht (13) umfasst, eine dritte Schicht auszubilden, die Tantaloxid aufweist, und
- SnOx zur vierten Schicht hinzugefügt wird.

7. Verfahren gemäß Anspruch 6, wobei:
beim Ausbilden (S13) der dritten Schicht eine amorphe Schicht, die Tantaloxid aufweist, oder eine Nanopartikelschicht, die mehrere Tantaloxid-Nanopartikel aufweist, durch Sputterdeposition, Dampfabscheidung oder lonenplattierung ausgebildet wird.

## Revendications

1. Batterie secondaire (100) comprenant :
une première électrode (21) ;
une seconde électrode (22) ;
une première couche (11) disposée entre la première électrode et la seconde électrode et comprenant un premier matériau semi-conducteur à oxyde de type n ;
une deuxième couche (12) disposée sur la première couche (11) et comprenant un second matériau semi-conducteur à oxyde de type n et un premier matériau isolant ;
une troisième couche (13) disposée sur la deuxième couche ; et
une quatrième couche (14) disposée sur la troisième couche et comprenant un second matériau isolant ; et
une couche (15 ; 16) comprenant de l'oxyde de nickel ou de l'hydroxyde de nickel formée entre la quatrième couche (14) et la seconde électrode (22),
dans laquelle la quatrième couche (14) est principalement composée de SiOx qui est le second matériau isolant,
**caractérisée en ce que** :
- la troisième couche (13) comprend de l'oxyde de tantale, et
- SnOx est ajouté à la quatrième couche.

2. Batterie secondaire selon la revendication 1, dans laquelle
la troisième couche (13) est une couche amorphe comprenant de l'oxyde de tantale ou une couche de nanoparticules comprenant une pluralité de nanoparticules d'oxyde de tantale.

3. Batterie secondaire selon la revendication 1 ou 2, dans laquelle l'épaisseur de la troisième couche (13) est supérieure ou égale à 50 nm et inférieure ou égale à 800 nm.

4. Batterie secondaire selon l'une quelconque des revendications 1 à 3, dans laquelle
le premier matériau isolant est SiOx, et
le second matériau semi-conducteur à oxyde de type n est TiO₂.

5. Batterie secondaire selon l'une quelconque des revendications 1 à 4, dans laquelle
le premier matériau semi-conducteur à oxyde de type n est TiO₂.

6. Procédé de fabrication d'une batterie secondaire (100) comprenant :
la formation (S11) d'une première couche (11) comprenant un premier matériau semi-conducteur à oxyde de type n sur une première électrode (21) ;
la formation (S12) d'une deuxième couche (12) comprenant un second matériau se-mi-conducteur à oxyde de type n et un premier matériau isolant sur la première couche (11) ;
la formation (S13) d'une troisième couche (13) sur la deuxième couche ;
la formation (S14) d'une quatrième couche (14) comprenant un second matériau isolant sur la troisième couche (13), la quatrième couche (14) étant principalement composée de SiOx qui est le second matériau isolant ; et
la formation (S16) d'une seconde électrode (22) sur la quatrième couche (14),
dans lequel une couche (15 ; 16) comprenant de l'oxyde de nickel ou de l'hydroxyde de nickel est formée entre la quatrième couche (14) et la seconde électrode (22),
**caractérisé en ce que** :
- la formation (S13) de la troisième couche (13) comprend la formation d'une troisième couche comprenant de l'oxyde de tantale, et
- SnOx est ajouté à la quatrième couche.

7. Procédé selon la revendication 6, dans lequel
lors de la formation (S13) de la troisième couche, une couche amorphe comprenant de l'oxyde de tantale ou une couche de nanoparticules comprenant une pluralité de nanoparticules d'oxyde de tantale est formée par dépôt par pulvérisation cathodique, dépôt en phase vapeur ou placage ionique.
